# EUROPEAN PATENT SPECIFICATION

(11) **EP 0 384 650 B1**
(45) Date of publication and mention of the grant of the patent: **21.06.1995**
(21) Application number: 90301636.8
(22) Date of filing: 15.02.1990
(51) Int. Cl.: H05K 5/00, F16B 2/20

(54) **A clip for securing a first part of a casing to a second**
Klammer zur Befestigung eines ersten Gehäuseteils an einem zweiten
Clip pour fixer une première partie d'un boîtier à une seconde

(30) Priority: 23.02.1989 GB 8904136
(43) Date of publication of application: 29.08.1990
(73) Proprietor: RESEARCH MACHINES PLC, Milton, Abingdon, Oxon OX14 4SE (GB)
(72) Inventor: Langley, Christopher Nigel, Warwickshire, CV31 2BL (GB)
(74) Representative: Unwin, Stephen Geoffrey

(56) References cited:
- FR-A- 2 056 335
- FR-A- 2 614 169

## Description

This invention relates to a clip for securing a first part of a casing to a second part thereof and more particularly, but not so restricted, for securing the lid of a microcomputer casing to a base portion of the casing.

The casings of microcomputers are manufactured from various materials such as plastics mouldings and sheet metal. The methods used to secure parts these casings together also vary.

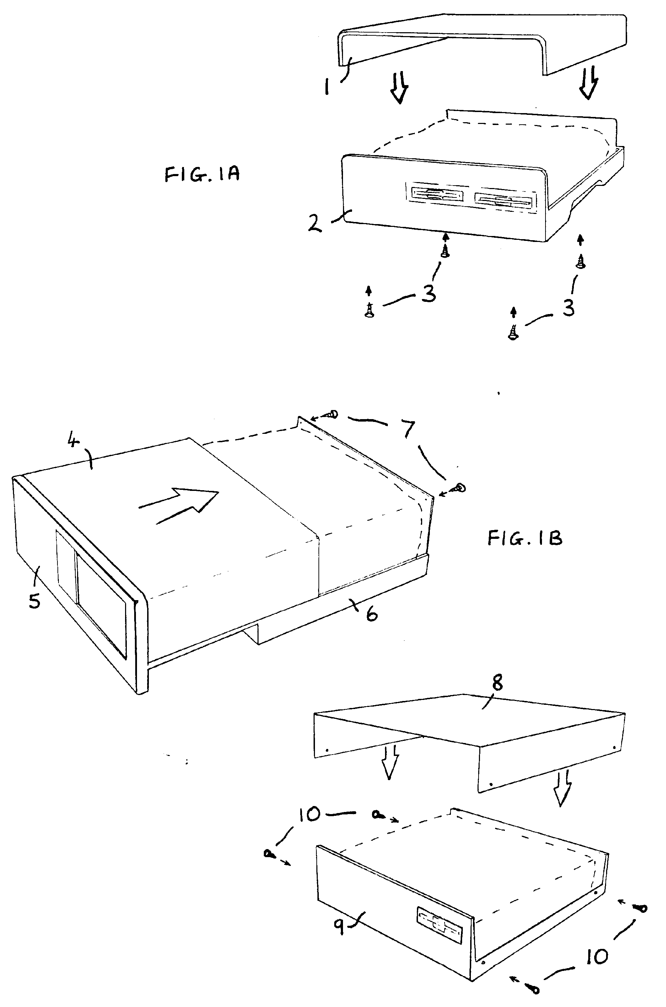

In the past a moulded plastics cover 1 of a microcomputer has been attached to a base moulding 2 by means of four screws 3 as shown in Figure 1A. However, microcomputers house many fragile components such as Winchester (Trade Mark) disc drives and floppy disc drives and this method requires that the unit is inverted to fit the screws into the base thereof. The risk of damaging components of the microcomputer increases if the unit has to be inverted in this way.

In an alternative arrangement, a metal cover 4 is first attached to the front cover 5 of a microcomputer and then slid rearwards onto a base unit 6 and secured to a rear panel by screws 7 as shown in Figure 1B. This method has the disadvantage that access is required to the rear of the microcomputer and a clear area is required in front of the unit in order that the cover can be slid forward when it is to be removed. In addition, it is necessary to remove the keyboard from the unit befoe the panel can be fitted or removed.

In another arrangement, a metal cover 8 is lowered onto a base unit 9 and secured by screws 10 in the side of the unit as shown in Figure 1C. The screws are therefore visible from the sides of the microcomputer and are unsightly.

The above methods also suffer from the following disadvantages:
* Threaded holes are required in the folded sheet metal lids. This is an added operation for the sheet metal worker and results in higher component costs.
* Threaded inserts are required in the moulded plastics covers. This an additional operation for the moulder and again results in higher component costs.
* The screws used to hold the casing together may easily be lost and if they are not replaced the cover will not be held securely in place.
* If the screws are visible, they act as an encouragement for people to remove them, particularly school children or other inquisitive owners. This can be avoided by using custom-designed screw heads but this results in the need for special tools and increased production costs.

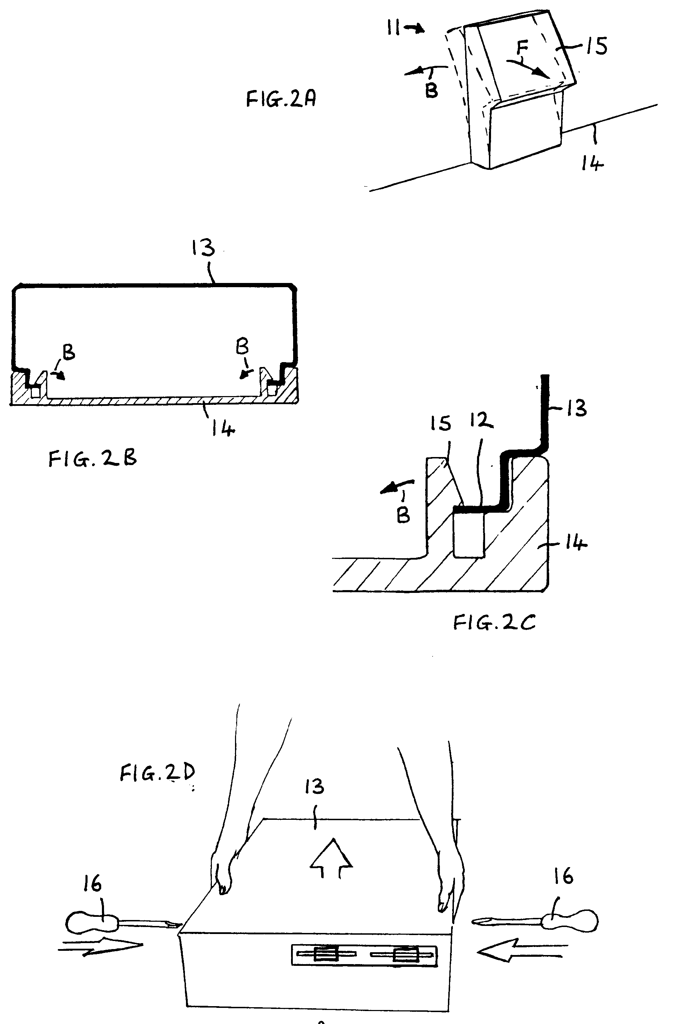

A further type of securement which has been used in other applications is a resilient clip 11 such as that shown in Figure 2A. This could be used in a microcomputer casing so that it is displaced in the direction B to the position shown in dotted lines by a flange 12 of a lid 13 (see the cross-sectional view in Figure 2B and the enlarged view in Figure 2C) as the lid 13 is fitted onto a base unit 14. The clip 11 would snap back into the unstressed position as shown by arrow F when the flange 12 is pushed past the head 15 of the clip 11. Although this may provide a secure fixing for the lid 13, it would be very awkward to remove the lid 13 again for servicing the microcomputer. To remove the lid 13, it would be necessary to press in simultaneously each of the clips 11, eg by means of screw drivers 16, and lift the lid 13 clear as illustrated by Figure 2D. This operation would almost certainly require two people.

FR-A- 2 614 169 disclosed electrical apparatus having a two-part housing, the two parts being held together by a clip arrangement that may be released by a tool insertable into the housing.

The present invention seeks to provide for the fast and simple assembly by hand of two parts of a casing whilst avoiding the problems described above. According to the present invention, there is provided a clip for securing two parts of a casing together, the clip being connected or connectable to a first part of the casing and having retention means for engaging and retaining a second part of the casing, the retention means being resiliently displacable in two substantially perpendicular directions such that, when the two parts of the casing are fitted together, displacement in both of these directions is required to allow the retention means to engage with and retain the second part of the casing, the retention means being arranged so that, in use, it is displaced in a first of the two directions by the second part of the casing as this is fitted to the first part and, when the retention means is displaced (by other means) in the second of the two directions, the displacement in the first direction is released allowing the retention means to engage and retain the second part of the casing and the retention means also being arranged so that, in use, it may be released from engagement with the second part of the casing by displacement in the said first direction whereby the displacement in the second direction is released so the retention means is prevented from re-engaging with the second part of the casing when the displacement in the first direction is released.

The invention also provides such a clip connected to the first part of the casing in combination with a second part of the casing for fitting and securing to the first part.

Preferred features of the invention, will be apparent from the following description and from the subsidiary claims of the specification.

The invention will now be further described, merely by way of example, with reference to the accompanying drawings, in which:
Figures 1A, 1B and 1C are perspective views illustrating three conventional methods of securing two parts of a casing together;
Figures 2A, 2B, 2C and 2D show various views showing a further method which has been proposed for securing two parts of a casing together using a conventional clip;
Figures 3A, 3B, 3C and 3D are various views of an embodiment of a clip according to the invention; and
Figures 4A, 4B, 4C and 4D are sectional views showing how the clip of Figure 3 is displaced as two parts of a casing are fitted together and also how it is displaced when the two parts are separated again.

The methods illustrated in Figures 1 and 2 have been described above in the discussion of the prior art.

The following description refers to the use of a clip for securing a lid or top cover of a microcomputer to a base portion thereof. However, it will be appreciated that the clip may also be used to secure two parts of any other type of casing together.

The cover may be secured to the base portion by a single clip although several clips are preferably used, eg one or more on each side of the cover.

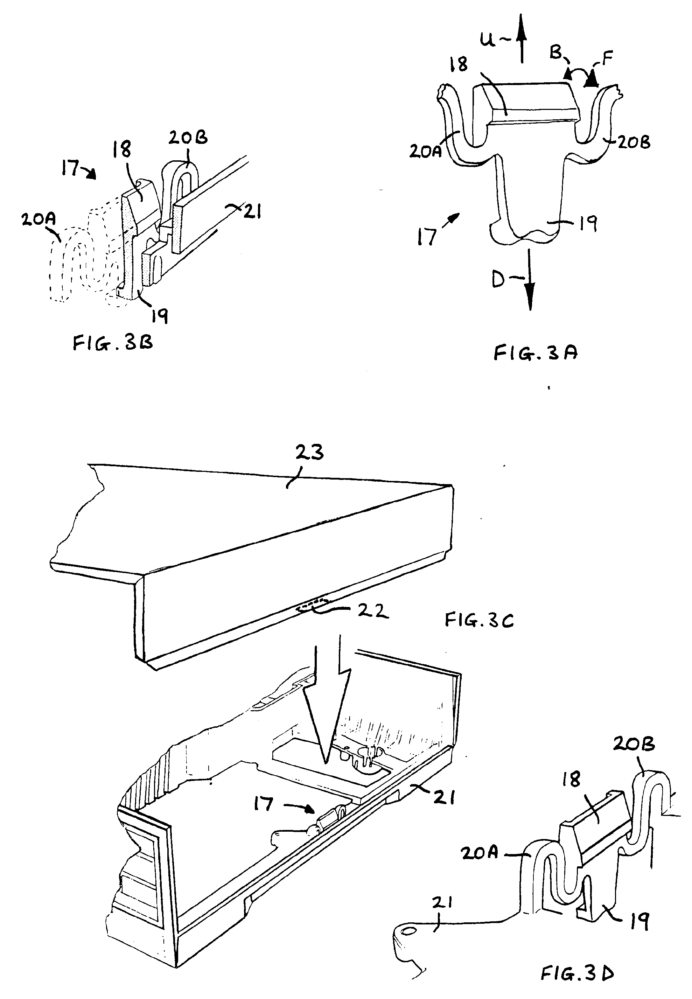

Figure 3A shows a plastics clip 17 comprising retention means 18 in the form of a projecting wedge, a lifting portion 19 and two resilient arms 20A and 20B which, in the arrangement shown, are S-shaped.

The clip 17 is integrally moulded with a base portion 21 of a microcomputer (as shown in the part broken away view of Figure 3B) and is connected thereto by means of the resilient arms 20A and 20B, one end of each S-shaped arm being connected to the clip 17 and the other end to the base portion 21 (see also the perspective view of Figure 3C and the enlarged view of Figure 3D). The retention means 18 may thus be resiliently displaced in two substantially perpendicular directions: the first direction is backwards and forwards as shown by arrows B and F corresponding to the displacement of the clip 11 shown in Figure 2 and the second direction is up and down as shown by the arrows U and D.

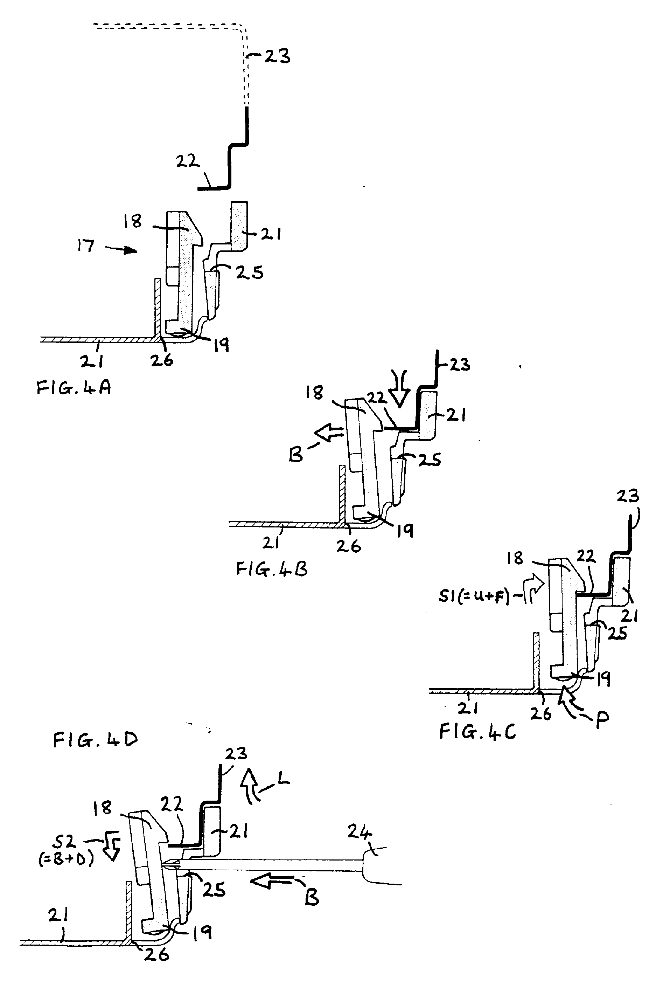

As will be described further below, the retention means 18 is displaced backwards in the direction of arrow B by a flange 22 on the cover 23 of the microcomputer as the cover 23 is fitted to the base portion 21. It may also be displaced in this direction by means of a screw driver 24 inserted through a first aperture 25 (see Figure 4) provided for access thereto in the side of the base portion 21 adjacent the retention means 18. The retention means 18 is moved upwards in the direction of arrow U by means of a finger (not shown) engaging the lifting portion 19 through a second aperture 26 (see Figure 4) provided for access thereto in the underside of the base portion 21 adjacent the retention means 18. The clip 17 is thus somewhat similar to that shown in Figure 2 but in addition to being compliant in the backwards and forwards direction it is also compliant in the upward and downward direction. The cover 23 is of conventional design but for the provision of the small flange 22 to engage the clip 17.

Other forms of clip which operate in a similar manner may be used in place of that shown in the drawings. The retention means may, for instance, be connected to the base portion of the microcomputer by other connection means, eg two resilient but substantially straight arms. Alternatively, the clip may be connected to the base portion by a spring plate or other resilient means attached to the base of the lifting portion of the clip.

The clip may be formed separately from the base portion and secured thereto, for instance by screws, attaching the resilient arms to the base portion. The clip may also be formed of other materials, eg metal.

Other forms of retention means may be used for engaging and retaining the second part of the casing and the retention means may be arranged to engage a projection on the second part of the casing or to engage a recess or slot provided therein.

Figures 4A-4C illustrate the manner in which the clip 17 is displaced as the cover 23 is fitted to the base portion 21. Figure 4A shows the cover 23 with its projecting flange 22 positioned above the clip 17. As the cover 23 is lowered into position, the flange 22 displaces the retention means 18 of the clip in the direction B as shown in Figure 4B thus putting it in horizontal strain. The flange 22 rides down the inclined surface of the wedge shaped retention means 18 but, unlike the arrangement shown in Figure 2, it comes to rest on a stepped part of the base portion 21 before it is able to pass the overhanging edge of the retention means 18.

To enable the retention means 18 to engage and retain the flange 22, it is necessary to displace the retention means 18 in the upwards direction U by pressing the lifting portion 19 from the underside of the base portion 21 as shown by the arrow P. The overhanging portion of the retention means 18 is thus moved past the flange 22 allowing the retention means 18 to snap back into an upright position by movement in the direction F as the horizonal strain is released. The retention means 18 is thus positioned to engage and retain the flange 22. The upward and forward displacement of the retention means 18 during this operation is shown by the arrow S1.

It will be appreciated that in the position shown in Figure 4C the retention means 18 remains displaced in the upward direction. The vertical strain therein thus firmly holds the flange 22 against the base portion 21.

To release the cover 23 from the base portion 21, it is necessary to disengage the retention means 18 from the flange 22. This is done by displacing the retention means 18 backwards in the direction B by means of a screw driver 24 inserted through the aperture 25 in the base portion 21. When the retention means 18 has been disengaged from the flange 22 in this manner, it is able to snap back to its lower position by movement in the direction D as the vertical strain therein is released. The screwdriver 24 is then removed. The backward and downward movement of the retention means 18 during this operation is shown by the arrow S2. The retention means 18 is thus returned to a position corresponding to that shown in Figure 4B so, unlike the arrangement shown in Figure 2, it does not re-engage the flange 22 when the screw driver 24 is removed. Each of the clips 17 used to secure the cover 23 to the base portion 21 can thus be disengaged in turn by one person leaving the cover 23 free to be lifted off the base portion 21 as shown by the arrow L in Figure 4C.

As will be appreciated from the above description of Figures 3 and 4, the clip 17 is substantially concealed within the casing when the cover 23 is fitted to the base portion 21 and is only visible by looking through the apertures 25 or 26.

Figures 3 and 4 also show that the mating edges of the cover 23 and base portion 21 have a stepped profile. This securely locates the cover 23 on the base portion 21 by preventing sideways movement between these two components. Both the base portion 21 and the cover 23 typically comprise plastics mouldings although metal plates may also be attached thereto for rigidity and to facilitate their connection.

The type of clip described has a number of advantages over the prior art:
* The microcomputer does not need to be inverted or otherwise re-orientated when the cover is fitted thereby reducing the risk of damage to the delicate internal components.
* No additional sub-assembly operations for the lid are required so reducing the component costs.
* The clip is concealed and not obvious to the uninformed and so provides a greater level of security to a standard screw.
* The clip may be used with either metal or plastics lids.
* The clip is an internal part of the base portion of the microcomputer and cannot therefore be mislaid.
* The retention method using the clip is fast and standard tools may be used to disengage or de-latch the clip.
* If a number of clips are used, they may be disengaged individually to permit removal of the lid unlike the clips shown in Figure 2.

## Claims

1. A clip for securing two parts (21,23) of a casing together, the clip (17) being connected or connectable to a first part (21) of the casing and having retention means (18) for engaging and retaining a second part (23) of the casing, the retention means (18) being resiliently displacable in two substantially perpendicular directions (U-D,B-F) such that, when the two parts (21,23) of the casing are fitted together, displacement in both of these directions is required to allow the retention means (18) to engage with and retain the second part (23) of the casing, the retention means (18) being arranged so that, in use, it is displaced in a first (B) of the two directions by the second part (23) of the casing as this is fitted to the first part (21) and, when the retention means (18) is displaced (by other means) in the second (U) of the two directions, the displacement in the first direction (B) is released allowing the retention means (18) to engage and retain the second part (23) of the casing and the retention means (18) also being arranged so that, in use, it may be released from engagement with the second part (23) of the casing by displacement in the said first direction (B) whereby the displacement in the second direction (U) is released so the retention means (18) is prevented from re-engaging with the second part (23) of the casing when the displacement in the first direction (B) is released.

2. A clip as claimed in claim 1 which is connected or connectable to the first part (21) of the casing by resilient arms (20A,20B) which permit the retention means (18) to be displaced in the said two directions.

3. A clip as claimed in claim 2 in which each of the arms (20A,20B) is S-shaped, one end thereof being attached to the clip (17) and the other being connected or connectable to the first part (21) of the casing.

4. A clip as claimed in claim 2 or 3 which is formed as an integral plastics moulding with the first part (21) of the casing.

5. A clip as claimed in any preceding claim in which the retention means (18) is arranged so that, in use, it remains displaced in the second (U) of the said directions when it is engaged with the second part (23) of the casing thereby holding the second part (23) of the casing against the first part (21).

6. A clip as claimed in any preceding claim connected to the first part (21) of the casing which is provided with a first aperture (25) adjacent the retention means (18) to permit entry of a tool, eg a finger or screwdriver (24), through the first part (21) of the casing to displace the retention means in the said first direction (B).

7. A clip as claimed in claim 6 in which a second aperture (26) is provided in the first part (21) of the casing adjacent the retention means (18) to permit entry of a tool, eg a finger or screwdriver, through the first part (21) of the casing to displace the retention means in the said second direction (U).

8. A clip as claimed in any preceding claim connected to the first part (21) of a casing in combination with a second part (23) of the casing for fitting and securing to the first part (21).

9. A combination as claimed in claim 8 in which the second part (23) of the casing is provided with a projection, eg a flange (22), arranged to be engaged and retained by the retention means (18) when the two parts (21,23) of the casing are fitted together.

10. A combination as claimed in claim 8 or 9 in which the first and second parts (21,23) of the casing are provided with mating edges each of which has a stepped profile.

11. A combination as claimed in claim 8, 9 or 10 in which the first part (21) of the casing is a base portion of a microcomputer and the second part (23) of the casing is a lid or cover for fitting to the base portion (21).

## Patentansprüche

1. Eine Klammer zum Aneinanderbefestigen von zwei Teilen (21,23) eines Gehäuses, wobei die Klammer (17) an einen ersten Teil (21) des Gehäuses angeschlossen wird oder angeschlossen werden kann und ein Haltemittel (18) zum Eingreifen in einen zweiten Teil (23) des Gehäuses und zum Festhalten des besagten zweiten Teils umfaßt, und zwar ist das Haltemittel (18) in zwei im wesentlichen senkrechten Richtungen (U-D,B-F) elastisch so verlagerungsfähig, daß, wenn die beiden Teile (21,23) des Gehäuses miteinander zusammengesetzt sind, Verlagerung in beiden dieser Richtungen erforderlich ist, damit das Haltemittel (18) in den zweiten Teil (23) des Gehäuses eingreifen und diesen festhalten kann, wobei das Haltemittel (18) so angeordnet ist, daß es bei Gebrauch durch den zweiten Teil (23) des Gehäuses in einer ersten (B) der beiden Richtungen verlagert wird, indem der besagte zweite Teil an dem ersten Teil (21) angebracht wird, und, wenn das Haltemittel (18) (auf andere Weise) in der zweiten (U) der beiden Richtungen verlagert wird, die Verlagerung in der ersten Richtung (B) aufgehoben wird, so daß das Haltemittel (18) in den zweiten Teil (23) des Gehäuses eingreifen und diesen festhalten kann, und auch das Haltemittel (18) so angeordnet ist, daß es bei Gebrauch durch Verlagerung in der besagten ersten Richtung (B) aus dem Eingriff mit dem zweiten Teil (23) des Gehäuses gelöst werden kann, wodurch die Verlagerung in der zweiten Richtung (U) aufgehoben wird, so daß das Haltemittel (18) nicht wieder in den zweiten Teil (23) des Gehäuses eingreifen kann, wenn die Verlagerung in der ersten Richtung (B) aufgehoben ist.

2. Eine Klammer nach Anspruch 1, die durch Verlagerung des Haltemittels (18) in den besagten beiden Richtungen gestattende elastische Arme (20A,20B) an den ersten Teil (21) des Gehäuses angeschlossen ist oder angeschlossen werden kann.

3. Eine Klammer nach Anspruch 2, bei der jeder der Arme (20A,20B) S-förmig ist, wobei ein Ende davon an der Klammer (17) angebracht und das andere an den ersten Teil (21) des Gehäuses angeschlossen ist oder angeschlossen werden kann.

4. Eine Klammer nach Anspruch 2 oder 3, die als ein mit dem ersten Teil (21) des Gehäuses einstückiger Kunststoffpreßling geformt ist.

5. Eine Klammer nach einem der vorstehenden Ansprüche, bei der das Haltemittel (18) so angeordnet ist, daß es bei Gebrauch in der zweiten (U) der besagten Richtungen verlagert bleibt, wenn es mit dem zweiten Teil (23) des Gehäuses in Eingriff ist, so daß der zweite Teil (23) des Gehäuses an den ersten Teil (21) gehalten wird.

6. Eine an den ersten Teil (21) des Gehäuses angeschlossene Klammer nach einem der vorstehenden Ansprüche, die mit einer ersten an das Haltemittel (18) anschließenden Öffnung (25) versehen ist, um zwecks Verlagerung des Haltemittels in der besagten ersten Richtung (B) das Einführen eines Werkzeugs, z.B. eines Fingers oder Schraubendrehers (24), durch den ersten Teil (21) des Gehäuses hindurch zu gestatten.

7. Eine Klammer nach Anspruch 6, bei der eine zweite an das Haltemittel (18) in dem ersten Teil (21) des Gehäuses anschließende Öffnung (26) vorgesehen ist, um zwecks Verlagerung des Haltemittels in der besagten zweiten Richtung (U) das Einführen eines Werkzeugs, z.B. eines Fingers oder Schraubendrehers, durch den ersten Teil (21) des Gehäuses hindurch zu gestatten.

8. Eine Klammer nach einem der vorstehenden Ansprüche, die zwecks Anbringung und Befestigung an dem ersten Teil (21) eines Gehäuses an den ersten Teil (21) in Verbindung mit einem zweiten Teil (23) des Gehäuses angeschlossen ist.

9. Eine Verbindung nach Anspruch 8, bei der der zweite Teil (23) des Gehäuses mit einem Vorsprung, z.B. einem Flansch (22), versehen ist, der so angeordnet ist, daß das Haltemittel (18) in ihn eingreift und ihn festhält, wenn die beiden Teile (21,23) des Gehäuses zusammengesetzt sind.

10. Eine Verbindung nach Anspruch 8 oder 9, bei der der erste und der zweite Teil (21,23) des Gehäuses mit zueinander passenden Rändern versehen sind, von denen jeder ein abgestuftes Profil aufweist.

11. Eine Verbindung nach Anspruch 8, 9 oder 10, bei der der erste Teil (21) des Gehäuses ein Fußteil eines Mikrocomputers und der zweite Teil (23) des Gehäuses ein Deckel oder eine Kappe zur Anbringung an dem Fußteil (21) ist.

## Revendications

1. Patte pour fixer ensemble deux parties (21,23) d'un boîtier, la patte (17) étant ou pouvant être reliée à une première partie (21) du boîtier et ayant un moyen de retenue (18) pour s'engager avec une deuxième partie (23) du boîtier et la retenir, le moyen de retenue (18) pouvant se déplacer élastiquement dans deux directions substantiellement perpendiculaires (U-D, B-F) de telle sorte que, lorsque les deux parties (21, 23) du boîtier sont assemblées, le déplacement dans ces deux directions est nécessaire pour permettre au moyen de retenue (18) de s'engager avec la deuxième partie (23) du boîtier et de la retenir, le moyen de retenue (18) étant disposé de telle sorte qu'en utilisation, il soit déplacé dans une première (B) des deux directions par la deuxième partie (23) du boîtier alors que celle-ci est assemblée avec la première partie (21) et, lorsque le moyen de retenue (18) est déplacé (par un autre moyen) dans la deuxième (U) des deux directions, le déplacement dans la première direction (B) est relâché, ce qui permet au moyen de retenue (18) de s'engager avec la deuxième partie (23) du boîtier et de la retenir, et le moyen de retenue (18) étant aussi disposé de telle sorte qu'en utilisation, il puisse être libéré de l'engagement avec la deuxième partie (23) du boîtier par déplacement dans ladite première direction (B), si bien que le déplacement dans la deuxième direction (U) est relâché de telle sorte que le moyen de retenue (18) ne peut plus se ré-engager avec la deuxième partie (23) du boîtier lorsque le déplacement dans la première direction (B) est relâché.

2. Patte selon revendication 1 qui est ou peut être reliée à la première partie (21) du boîtier par des bras élastiques (20A,20B) qui permettent au moyen de retenue (18) de se déplacer dans lesdites deux directions.

3. Patte selon revendication 2 dans laquelle chacun des bras (20A,20B) est en forme de S, une de leurs extrémités étant fixée à la patte (17) et l'autre étant ou pouvant être reliée à la première partie (21) du boîtier.

4. Patte selon revendication 2 ou 3 qui est constituée d'une moulure en plastique faisant partie intégrante de la première partie (21) du boîtier.

5. Patte selon l'une quelconque des revendications précédentes, dans laquelle le moyen de retenue (18) est disposé de telle sorte qu'en utilisation, il reste déplacé dans la deuxième (U) desdites directions lorsqu'il est engagé avec la deuxième partie (23) du boîtier, retenant ainsi la deuxième partie (23) du boîtier contre la première partie (21).

6. Patte selon l'une quelconque des revendications précédentes, reliée à la première partie (21) du boîtier, qui est munie d'une première ouverture (25) proche du moyen de retenue (18) pour permettre l'introduction d'un outil, par ex. un doigt ou un tournevis (24), à travers la première partie (21) du boîtier pour déplacer le moyen de retenue dans ladite première direction (B).

7. Patte selon revendication 6, dans laquelle une deuxième ouverture (26) est prévue dans la première partie (21) du boîtier à proximité du moyen de retenue (18) pour permettre l'introduction d'un outil, par ex. un doigt ou un tournevis, à travers la première partie (21) du boîtier pour déplacer le moyen de retenue dans ladite deuxième direction (U).

8. Patte selon l'une quelconque des revendications précédentes reliée à la première partie (21) d'un boîtier en combinaison avec une deuxième partie (23) du boîtier pour l'assembler et la fixer à la première partie (21).

9. Combinaison selon revendication 8 dans laquelle la deuxième partie (23) du boîtier est munie d'une saillie, par ex. un rebord (22), agencée de manière à s'engager avec le moyen de retenue (18) et à être retenue par ce dernier lorsque les deux parties (21,23) du boîtier sont assemblées.

10. Combinaison selon revendication 8 ou 9 dans laquelle la première et la deuxième parties (21,23) du boîtier sont munies de bords correspondants dont chacun a un profil en gradin.

11. Combinaison selon revendication 8, 9 ou 10 dans laquelle la première partie (21) du boîtier est une partie de base d'un micro-ordinateur et la deuxième partie (23) du boîtier est un couvercle ou capot qui se monte sur la partie de base (21).
